# EUROPÄISCHE PATENTSCHRIFT

(11) **EP 4 361 657 B1**
(45) Veröffentlichungstag und Bekanntmachung des Hinweises auf die Patenterteilung: **15.07.2026**
(21) Anmeldenummer: 23202569.2
(22) Anmeldetag: 10.10.2023
(51) Int. Cl.: G01R 31/58

(54) **VERFAHREN ZUR ISOLATIONSPRÜFUNG VON ELEKTRISCHEN NETZWERKEN EINES KABELBAUMS**
METHOD FOR INSULATION TESTING OF ELECTRICAL NETWORKS OF A CABLE HARNESS
PROCÉDÉ DE TEST D'ISOLATION DE RÉSEAUX ÉLECTRIQUES D'UN FAISCEAU DE CÂBLES

(30) Priorität: 27.10.2022 DE 102022128550
(43) Veröffentlichungstag der Anmeldung: 01.05.2024
(73) Patentinhaber: Lisa Dräxlmaier GmbH, 84137 Vilsbiburg (DE)
(72) Erfinder: Ehrhardt, Othmar, 84326 Rimbach (DE)

(56) Entgegenhaltungen:
- EP-B1- 3 422 027
- WO-A1-2021/019400
- CN-A- 113 219 372
- US-A- 5 029 274

## Beschreibung

### Technisches Gebiet

Die vorliegende Erfindung betrifft ein Verfahren und ein System zur Isolationsprüfung einer Mehrzahl von elektrischen Netzwerken eines Kabelbaumes, insbesondere eines Kabelbaums im Automotive-Bereich, sowie ein entsprechendes Computerprogramm und computerlesbares Speichermedium. Die Erfindung betrifft insbesondere die Isolationsprüfung elektrischer Netzwerke.

### Stand der Technik

Netzwerke in Kabelbäumen werden üblicherweise auf Leitungsebene durchgemessen ("durchgeklingelt"). Hierfür sind in jedem Messschritt zwei Steckkontakte involviert, alle anderen Steckkontakte sind nicht beteiligt. Die Messungen werden also nacheinander durchgeführt was einen hohen Zeitaufwand und Arbeitsaufwand bedeutet.

CN 113 219 372 A beschreibt eine Erfassungseinrichtung für Kabel, ein Verfahren zur Erfassung des Leitungswiderstands und ein Verfahren zur Erfassung des Isolationswiderstands. Die Einrichtung umfasst eine Relaisanordnung, eine Erfassungssteuerplatine und eine Stromversorgungseinheit, wobei eine Seite der Relaisanordnung mit der Erfassungssteuerplatine verbunden ist, die andere Seite der Relaisanordnung mit zwei Enden der Kabeladern eines erfassten Kabels verbunden ist und die Relaisanordnung zum Anlegen ein Erkennungssignal zwischen jeweils zwei Adern des erkannten Kabels angelegt wird; die Erkennungssteuerplatine wird zum Schalten verwendet, um eine Leitungs- oder Isolationswiderstandserkennung am erkannten Kabel durchzuführen und ein entsprechendes Erkennungssignal zu erzeugen; und die Stromversorgungseinheit ist mit der Erkennungssteuerplatine verbunden und wird verwendet, um Strom bereitzustellen.

US 5 029 274 A beschreibt eine Vorrichtung zum Testen der Unversehrtheit von Kabeln umfasst einen Sender und einen Empfänger, die elektrisch mit den gegenüberliegenden Enden einer zu testenden Gruppe von Drähten verbunden werden. Der Sender erzeugt ein Spannungstestsignal, das an einen Testsatz von Drähten angelegt wird, und ein anderes Spannungsreferenzsignal wird an einen Referenzsatz von Drähten angelegt. Am Empfänger verbinden Anzeigeschaltungen die Drähte mit einem gemeinsamen Bus. Das Referenzsignal wird an den gemeinsamen Bus angelegt und wenn das Testsignal vorhanden ist, erzeugen die Anzeigen eine Anzeige. Das Testsignal kann durch eine Vielzahl von Testsätzen, die die gesamte Testgruppe bilden, zyklisch durchlaufen werden.

### Beschreibung der Erfindung

Eine Aufgabe der Erfindung ist es daher, ein vorteilhaftes Konzept zur verbesserten Isolationsprüfung von Netzwerken in Kabelbäumen zu schaffen, insbesondere ein Konzept, bei dem sich der Zeit- und Arbeitsaufwand reduzieren lässt.

Die Aufgabe wird durch die Gegenstände der unabhängigen Ansprüche gelöst. Vorteilhafte Weiterbildungen der Erfindung sind in den abhängigen Ansprüchen, der Beschreibung und den begleitenden Figuren angegeben.

Mit den hier beschriebenen Verfahren ist es möglich, komplexe elektrische Netzwerke in Kabelbäumen parallel durch kleine, selbstständig arbeitende Messeinheiten auf korrekte und kurzschlussfreie Verbindung durchzutesten. Ein Kabelbaum - es kann sich hierbei natürlich auch um eine komplexe Platine oder ähnliches handeln - besteht aus mehreren Steckern mit Steckkontakten, welche über Leitungen mit anderen Steckkontakten in demselben oder anderen Steckern elektrisch verbunden sind. Als ein Netzwerk werden Gruppen von Steckkontakten bezeichnet, die elektrisch leitend verbunden sind. Unterschiedliche Netzwerke im gleichen Kabelstrang dürfen elektrisch nicht verbunden sein. Dies muss überprüft werden, um später eine korrekte Funktion des Kabelbaumes zu gewährleisten.

Die erfinderische Lösung basiert auf der Idee, alle Netzwerke eines Kabelbaumes in zwei Gruppen aufzuteilen. Eine Gruppe wird elektrisch auf GND (Masse) gelegt und in der anderen Gruppe kann jeder Steckkontakt unabhängig von den anderen Kontakten in der Gruppe durch Aufschalten einer Spannungsquelle auf Stromfluss zu GND überprüft werden. Fließt kein Strom, ist der Steckkontakt nicht mit der ersten Gruppe verbunden und somit korrekt isoliert.

Die zwei Gruppen von Netzwerken werden durch besondere Weise in jedem Messschritt neu gruppiert, so dass nach Durchlauf von wenigen Messschritten jedes Netzwerk einmal gegen jedes andere Netzwerk gemessen wurde.

Mit dieser erfinderischen Lösung ergeben sich die technischen Vorteile einer Reduktion von Prüfzeiten in der Produktion von Kabelbäumen und einer verbesserten Ausnutzung von vorhandenen Prüfmitteln durch den parallelen Einsatz der Prüfmittel bzw. der Prüfhardware. Ferner ist es möglich, vorhandene Hardware zum Prüfen der Kabelbäume mit der erfinderischen Lösung parallel einzusetzen, um die Prüfzeiten in der Produktion signifikant zu reduzieren.

Gemäß einem ersten Aspekt wird die oben beschriebene Aufgabe gelöst durch ein Verfahren zur Isolationsprüfung einer Mehrzahl von elektrischen Netzwerken eines Kabelbaumes untereinander, wobei jedes elektrische Netzwerk eine Gruppe von elektrischen Kontakten umfasst, welche über elektrische Leitungen untereinander verbunden sind; wobei das Verfahren folgendes umfasst: Gruppieren der Mehrzahl von elektrischen Netzwerken in eine erste Netzwerkgruppe von elektrischen Netzwerken und eine zweite Netzwerkgruppe von elektrischen Netzwerken gemäß einem Gruppierungsschema; Aufschalten eines ersten elektrischen Potentials an einen ersten Kontakt der Gruppe von elektrischen Kontakten eines jeden elektrischen Netzwerks der ersten Netzwerkgruppe und Aufschalten eines zweiten elektrischen Potentials, das sich von dem ersten elektrischen Potential unterscheidet, an die verbleibenden Kontakte der Gruppe von elektrischen Kontakten jedes elektrischen Netzwerks der ersten Netzwerkgruppe sowie an alle elektrischen Kontakte der Gruppe von elektrischen Kontakten jedes elektrischen Netzwerks der zweiten Netzwerkgruppe; Prüfen der an das zweite elektrische Potential geschalteten elektrischen Kontakte der zweiten Netzwerkgruppe auf Stromfluss; und Detektieren einer elektrischen Isolation zwischen den elektrischen Netzwerken der zweiten Netzwerkgruppe und den elektrischen Netzwerken der ersten Netzwerkgruppe, falls das Prüfen der an das zweite elektrische Potential geschalteten Kontakte der zweiten Netzwerkgruppe jeweils ergeben hat, dass kein Strom fließt.

Mit diesem Verfahren wird ein vorteilhaftes Konzept zur verbesserten Isolationsprüfung in der Kabelbaumfertigung realisiert. Damit ergeben sich als technische Vorteile eine Reduktion von Prüfzeiten in der Produktion von Kabelbäumen und eine verbesserte Ausnutzung von vorhandenen Prüfmitteln durch deren parallelen Einsatz.

Gemäß dem Verfahren nimmt das Gruppierungsschema in einem ersten Schritt eine erste Gruppierung der elektrischen Netzwerke vor und in einem zweiten Schritt eine zweite Gruppierung der elektrischen Netzwerke, die sich von der ersten Gruppierung unterscheidet; wobei das Aufschalten der elektrischen Potentiale, das Prüfen der Kontakte der zweiten Netzwerkgruppe auf Stromfluss und das Detektieren der elektrischen Isolation für den zweiten Schritt wiederholt wird.

Damit wird der technische Vorteil erreicht, dass die Prüfung auf elektrische Isolation auf eine zweite Gruppierung der Netzwerke angewandt wird, die sich von der ersten Gruppierung unterscheidet. Bei einem entsprechend ausgelegten Gruppierungsschema reichen bereits wenige Schritte aus, um alle Netzwerke auf Isolation durchzuprüfen.

Gemäß dem Verfahren nimmt das Gruppierungsschema in weiteren Schritten jeweils weitere Gruppierungen der elektrischen Netzwerke vor, die sich von vorhergehenden Gruppierungen unterscheiden; wobei das Aufschalten der elektrischen Potentiale, das Prüfen der Kontakte der zweiten Netzwerkgruppe auf Stromfluss und das Detektieren der elektrischen Isolation für die weiteren Schritte wiederholt wird, bis keine weitere Gruppierung mehr vorliegt, die sich von den vorhergehenden Gruppierungen unterscheidet.

Damit wird der technische Vorteil erreicht, dass die Prüfung auf elektrische Isolation auf weitere Gruppierungen der Netzwerke angewandt wird, die unterschiedlich zu den vorhergehenden Gruppierungen sind. Bei geeignetem Gruppierungsschema kann bereits nach wenigen Schritten eine vollständige Überprüfung der Netzwerke auf elektrische Isolation durchgeführt werden. Das Verfahren führt somit zu einer Reduktion der Prüfzeiten in der Produktion von Kabelbäumen und einer verbesserten Ausnutzung von Prüfmitteln durch ihren parallelen Einsatz.

Gemäß einer beispielhaften Ausführungsform des Verfahrens umfasst die Mehrzahl von elektrischen Netzwerken eine Anzahl von elektrischen Netzwerken, die eine Zweierpotenz ist; und wobei das Aufschalten der elektrischen Potentiale, das Prüfen der Kontakte der zweiten Netzwerkgruppe auf Stromfluss und das Detektieren der elektrischen Isolation jeweils für eine Anzahl an Schritten durchgeführt wird, die dem Exponenten der Zweierpotenz entspricht.

Bei einer solchen Anzahl von Netzwerken kann eine optimale Überprüfung auf Isolation innerhalb kürzester Zeit durchgeführt werden. Denn bei einer Zweierpotenz von elektrischen Netzwerken kann eine vollständige Überprüfung bereits nach einer Anzahl von Schritten erfolgen, die dem Exponenten der Zweierpotenz entspricht. Beispielsweise reichen bei acht Netzwerken bereits drei Schritte aus oder bei 16 Netzwerken reichen bereits vier Schritte aus.

Gemäß einer beispielhaften Ausführungsform des Verfahrens nimmt das Gruppierungsschema eine gleichmäßige Gruppierung vor, bei der die erste Netzwerkgruppe und die zweite Netzwerkgruppe eine gleiche Anzahl von elektrischen Netzwerken umfassen oder bei der die jeweiligen Anzahlen sich um nicht mehr als Eins voneinander unterscheiden.

Damit wird der technische Vorteil erreicht, dass die beiden Gruppen die gleiche oder fast die gleiche Anzahl von Netzwerken umfassen und sich der Prüfaufwand gleichmäßig auf beiden Gruppen verteilt. Dann kann auch mit der gleichen Prüf-Hardware zuerst die erste Gruppe und danach die zweite Gruppe geprüft werden.

Gemäß einer beispielhaften Ausführungsform des Verfahrens erfolgt das Aufschalten des ersten elektrischen Potentials und das Aufschalten des zweiten elektrischen Potentials an die jeweiligen Kontakte eines Netzwerks der ersten Netzwerkgruppe gleichzeitig oder nacheinander oder gruppenweise.

Damit wird der technische Vorteil erreicht, dass bei gleichzeitigem Aufschalten sich die Prüfzeit besonders stark reduzieren lässt, bei nacheinander folgendem Aufschalten kann besonders ressourcenschonend gearbeitet werden; beispielsweise kann dafür dieselbe Spannungs- oder Stromquelle genutzt werden. Bei einem gruppenweisen Aufschalten ergeben sich Vorteile bezüglich Prüfzeit und Ressourcen.

Gemäß einer beispielhaften Ausführungsform des Verfahrens erfolgt das Aufschalten des ersten elektrischen Potentials und das Aufschalten des zweiten elektrischen Potentials an die jeweiligen Kontakte eines zweiten Netzwerks der ersten Netzwerkgruppe gleichzeitig oder anschließend an das Aufschalten des ersten elektrischen Potentials und das Aufschalten des zweiten elektrischen Potentials an die jeweiligen Kontakte eines ersten Netzwerks der ersten Netzwerkgruppe.

Damit wird der technische Vorteil erreicht, dass Flexibilität möglich ist beim Prüfen der Isolation hinsichtlich Reduktion der Prüfzeit und parallelem Einsatz von Ressourcen.

Gemäß einer beispielhaften Ausführungsform des Verfahrens erfolgt das Aufschalten des zweiten elektrischen Potentials an die jeweiligen Kontakte eines Netzwerks der zweiten Netzwerkgruppe gleichzeitig oder anschließend an das Aufschalten des zweiten elektrischen Potentials an die jeweiligen Kontakte eines Netzwerks der ersten Netzwerkgruppe.

Damit wird der technische Vorteil erreicht, dass auch hiermit Flexibilität möglich ist beim Prüfen der Isolation hinsichtlich Reduktion der Prüfzeit und parallelem Einsatz von Ressourcen.

Gemäß einer beispielhaften Ausführungsform des Verfahrens ist das erste elektrische Potential ein Masse-Potential; und das zweite elektrische Potential ein Referenzpotential, das durch ein Anlegen einer Referenzspannung oder eines Referenzstroms erzeugt wird.

Damit wird der technische Vorteil erreicht, dass sich das Verfahren leicht ausführen lässt. Bei bekanntem Massepotential und Referenzpotential ist auch die Differenz zwischen ihnen bekannt bzw. lässt sich so einstellen, dass ein gewünschter Prüfstrom in der Verbindungsleitung zwischen beiden Potentialen auftritt, der sich mit den zur Verfügung stehenden Messgeräten leicht messen bzw. detektieren lässt.

Gemäß einer beispielhaften Ausführungsform des Verfahrens umfasst das Verfahren folgendes: Prüfen der an das zweite Potential geschalteten Kontakte der ersten Netzwerkgruppe auf Stromfluss; und Detektieren einer Vollständigkeit der elektrischen Netzwerke der ersten Netzwerkgruppe, falls das Prüfen der an das zweite Potential geschalteten Kontakte der ersten Netzwerkgruppe jeweils einen Stromfluss ergeben hat.

Mit Vollständigkeit ist hier gemeint, dass alle elektrischen Kontakte eines elektrischen Netzwerks untereinander elektrisch verbunden sind. Somit ist keine elektrische Leitung, welche die elektrischen Kontakte des elektrischen Netzwerks untereinander verbindet, unterbrochen bzw. fehlerhaft.

Damit wird der technische Vorteil erreicht, dass nicht nur eine Isolationsprüfung der Netzwerke gegeneinander durchgeführt werden kann, sondern zugleich auch eine Prüfung auf Vollständigkeit der einzelnen Netzwerke. Beispielsweise lässt sich damit ein Kabelbruch oder auch ein anderer Defekt der Verbindungsleitung auf effiziente Weise erkennen.

Gemäß einer beispielhaften Ausführungsform des Verfahrens umfasst das Verfahren folgendes: Umschalten des zweiten elektrischen Potentials auf das erste elektrische Potential an einem ersten Kontakt der Gruppe von elektrischen Kontakten eines jeden elektrischen Netzwerks der zweiten Netzwerkgruppe; Prüfen der an das zweite Potential geschalteten Kontakte der zweiten Netzwerkgruppe auf Stromfluss; und Detektieren einer Vollständigkeit der elektrischen Netzwerke der zweiten Netzwerkgruppe, falls das Prüfen der an das zweite Potential geschalteten Kontakte der zweiten Netzwerkgruppe jeweils einen Stromfluss ergeben hat.

Damit wird der technische Vorteil erreicht, dass nicht nur die erste Netzwerkgruppe, sondern auch die zweite Netzwerkgruppe und somit die Netzwerke des gesamten Kabelbaums auf Vollständigkeit geprüft werden kann.

Gemäß einer beispielhaften Ausführungsform des Verfahrens umfasst zumindest ein elektrischer Kontakt von zumindest einem elektrischen Netzwerk einen Steckkontakt.

Damit wird der technische Vorteil erreicht, dass Kabelbäume mit üblichen Steckkontakten auf elektrische Isolation überprüft werden können.

Gemäß einem zweiten Aspekt wird die oben beschriebene Aufgabe gelöst durch ein Computerprogramm nach Anspruch 11.

Das Computerprogramm umfasst insbesondere Befehle, die bei der Ausführung des Programms durch einen Computer diesen veranlassen, das Verfahren gemäß dem oben beschriebenen ersten Aspekt auszuführen.

Damit wird der technische Vorteil erreicht, dass das Computerprogramm einfach auf einem Prüfsystem mit entsprechender Prüfhardware ausgeführt werden kann.

Gemäß einem dritten Aspekt wird die oben beschriebene Aufgabe gelöst durch ein computerlesbares Speichermedium nach Anspruch 12.

Das computerlesbares Speichermedium umfasst insbesondere Befehle, die bei der Ausführung durch einen Computer diesen veranlassen, das Verfahren gemäß dem oben beschriebenen ersten Aspekt auszuführen.

Damit wird der technische Vorteil erreicht, dass sich das Verfahren effizient in Form von Befehlen eines Computerprogramms auf einem üblichen Speichermedium, wie beispielsweise einem Datenträger, abspeichern lässt.

Gemäß einem vierten Aspekt wird die oben beschriebene Aufgabe gelöst durch ein Prüfsystem zur Isolationsprüfung einer Mehrzahl von elektrischen Netzwerken eines Kabelbaumes untereinander nach Anspruch 13.

Jedes elektrische Netzwerk umfasst insbesondere eine Gruppe von elektrischen Kontakten, welche über elektrische Leitungen untereinander verbunden sind; wobei das Prüfsystem insbesondere folgendes umfasst: eine Systemkomponente zum Gruppieren der Mehrzahl von elektrischen Netzwerken in eine erste Netzwerkgruppe von elektrischen Netzwerken und eine zweite Netzwerkgruppe von elektrischen Netzwerken gemäß einem Gruppierungsschema; eine Systemkomponente zum Aufschalten eines ersten elektrischen Potentials an einen ersten Kontakt der Gruppe von elektrischen Kontakten eines jeden elektrischen Netzwerks der ersten Netzwerkgruppe und zum Aufschalten eines zweiten elektrischen Potentials, das sich von dem ersten elektrischen Potential unterscheidet, an die verbleibenden Kontakte der Gruppe von elektrischen Kontakten jedes elektrischen Netzwerks der ersten Netzwerkgruppe sowie an alle Kontakte der Gruppe von elektrischen Kontakten jedes elektrischen Netzwerks der zweiten Netzwerkgruppe; eine Systemkomponente zum Prüfen der an das zweite Potential geschalteten Kontakte der zweiten Netzwerkgruppe auf Stromfluss; und eine Systemkomponente zum Detektieren einer elektrischen Isolation zwischen den elektrischen Netzwerken der zweiten Netzwerkgruppe und den elektrischen Netzwerken der ersten Netzwerkgruppe, falls das Prüfen der an das zweite Potential geschalteten Kontakte der zweiten Netzwerkgruppe jeweils ergeben hat, dass kein Strom fließt.

Ein solches Prüfsystem bietet die gleichen technischen Vorteile, wie das oben beschriebene Verfahren, d.h., es kann ein vorteilhaftes Konzept zur verbesserten Isolationsprüfung in der Kabelbaumfertigung realisiert werden. Damit ergeben sich als technische Vorteile eine Reduktion von Prüfzeiten in der Produktion von Kabelbäumen und eine verbesserte Ausnutzung von vorhandenen Prüfmitteln durch deren parallelen Einsatz.

### Kurze Figurenbeschreibung

Im Folgenden wird die Erfindung anhand von Ausführungsbeispielen und den Figuren näher beschrieben. Es zeigen:
- Fig. 1: eine schematische Darstellung eines erfindungsgemäßen Verfahrens 100 zur Isolationsprüfung von elektrischen Netzwerken eines Kabelbaumes untereinander;
- Fig. 2a,b,c: jeweils schematische Darstellungen beispielhafter elektrischer Netzwerke 11, 12, 13;
- Fig. 3: eine schematische Darstellung eines erfindungsgemäßen Verfahrens 200 zur Isolationsprüfung von elektrischen Netzwerken eines Kabelbaumes untereinander; und
- Fig. 4: eine schematische Darstellung eines erfindungsgemäßen Prüfsystems 400 zur Isolationsprüfung von elektrischen Netzwerken eines Kabelbaumes untereinander.

Die Figuren sind lediglich schematische Darstellungen und dienen nur der Erläuterung der Erfindung. Gleiche oder gleichwirkende Elemente sind durchgängig mit den gleichen Bezugszeichen versehen.

In der folgenden ausführlichen Beschreibung wird auf die beiliegenden Zeichnungen Bezug genommen, die einen Teil hiervon bilden und in denen als Veranschaulichung spezifische Ausführungsformen gezeigt sind, in denen die Erfindung ausgeführt werden kann. Es versteht sich, dass auch andere Ausführungsformen genutzt und strukturelle oder logische Änderungen vorgenommen werden können, ohne von dem Konzept der vorliegenden Erfindung abzuweichen. Die folgende ausführliche Beschreibung ist deshalb nicht in einem beschränkenden Sinne zu verstehen. Ferner versteht es sich, dass die Merkmale der verschiedenen hierin beschriebenen Ausführungsbeispiele miteinander kombiniert werden können, sofern nicht spezifisch etwas anderes angegeben ist.

Die Aspekte und Ausführungsformen werden unter Bezugnahme auf die Zeichnungen beschrieben, wobei gleiche Bezugszeichen sich im Allgemeinen auf gleiche Elemente beziehen. In der folgenden Beschreibung werden zu Erläuterungszwecken zahlreiche spezifische Details dargelegt, um ein eingehendes Verständnis von einem oder mehreren Aspekten der Erfindung zu vermitteln. Für einen Fachmann kann es jedoch offensichtlich sein, dass ein oder mehrere Aspekte oder Ausführungsformen mit einem geringeren Grad der spezifischen Details ausgeführt werden können. In anderen Fällen werden bekannte Strukturen und Elemente in schematischer Form dargestellt, um das Beschreiben von einem oder mehreren Aspekten oder Ausführungsformen zu erleichtern. Es versteht sich, dass andere Ausführungsformen genutzt und strukturelle oder logische Änderungen vorgenommen werden können, ohne von dem Konzept der vorliegenden Erfindung abzuweichen.

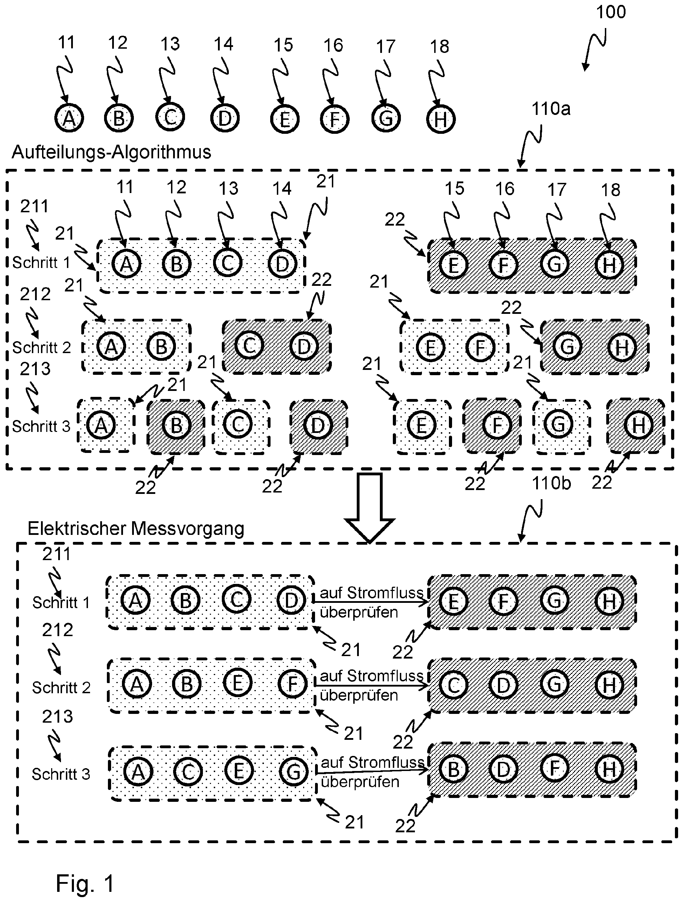

Fig. 1 zeigt eine schematische Darstellung eines erfindungsgemäßen Verfahrens 100 zur Isolationsprüfung von elektrischen Netzwerken eines Kabelbaumes untereinander.

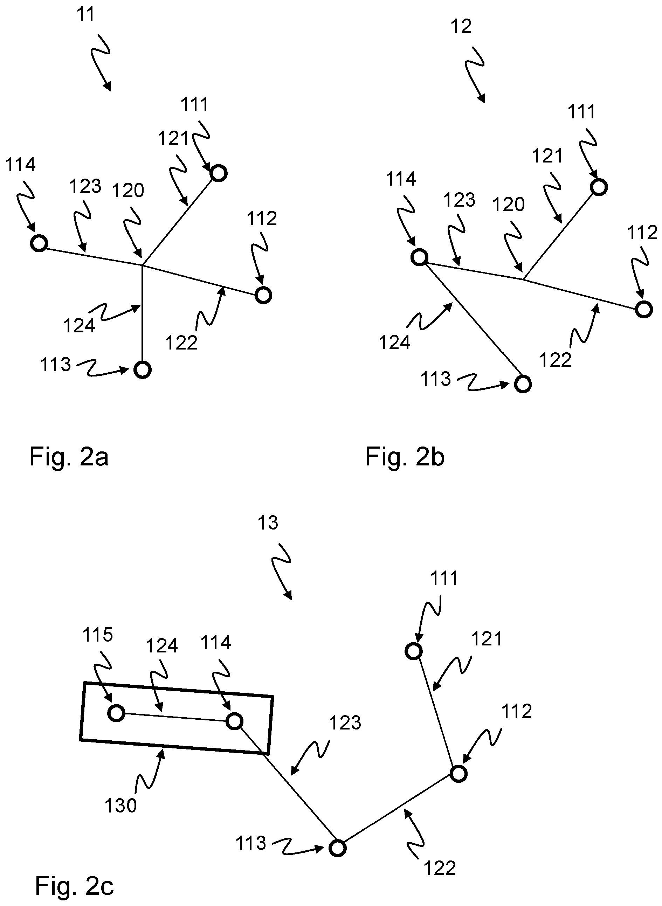

In diesem Beispiel wird eine Anzahl von acht Netzwerken 11, 12, 13, 14, 15, 16, 17, 18 des Kabelbaumes, welche mit den jeweiligen Buchstaben A, B, C, D, E, F, G, H bezeichnet sind und oben in Figur 1 dargestellt sind, auf elektrische Isolation zueinander geprüft. Beispiele für solche Netzwerke sind in Figur 2 dargestellt und weiter unten zu Figur 2 beschrieben.

Das Verfahren 100 umfasst einen Aufteilungs-Algorithmus 110a (im oberen Teil der Figur 1 dargestellt) und einen elektrischen Messvorgang 110b (im unteren Teil der Figur 1 dargestellt). Es werden jeweils eine beispielhafte Anzahl von drei Schritten 211, 212, 213 nacheinander ausgeführt. D.h. zuerst Schritt 1 des Aufteilungs-Algorithmus 110a und daran anschließend Schritt 1 des elektrischen Messvorgangs 110b. Danach Schritt 2 des Aufteilungs-Algorithmus 110a und daran anschließend Schritt 2 des elektrischen Messvorgangs 110b. Zuletzt Schritt 3 des Aufteilungs-Algorithmus 110a und daran anschließend Schritt 3 des elektrischen Messvorgangs 110b.

Als Voraussetzung sind alle Kontakte des Kabelbaumes elektrisch mit einem Prüf- oder Testsystem verbunden.

Die Messungen werden in Schritte aufgeteilt, die Schritte werden nacheinander durchgeführt. Innerhalb der Schritte kann die Messung parallelisiert werden. Für die in Figur 1 dargestellten beispielhaften acht Netzwerke A, B, C, D, E, F, G, H mit jeweils vier Leitungen sind lediglich drei Schritte 211, 212, 213 für die komplette Prüfung des Kabelbaumes notwendig.

Für jeden Schritt 211, 212, 213 wird die Gesamtheit der Netzwerke in zwei Gruppen 21, 22 aufgeteilt, es wird lediglich überprüft, ob die beiden Gruppen voneinander isoliert sind.

Die Aufteilung 110a und die Messung 110b wird für dieses Beispiel mit acht Netzwerken A, B, C, D, E, F, G, H wie folgt vorgenommen.

Im Schritt 1 werden die Netzwerke A, B, C, D der ersten Gruppe 21 zugeteilt und die Netzwerke E, F, G, H der zweiten Gruppe 22 zugeteilt. Dann werden die Netzwerke A, B, C, D der ersten Gruppe 21 gegenüber den Netzwerken E, F, G, H der zweiten Gruppe 22 auf Stromfluss überprüft.

Im Schritt 2 werden die Netzwerke A, B, E, F der ersten Gruppe 21 zugeteilt und die Netzwerke C, D, G, H der zweiten Gruppe 22 zugeteilt. Dann werden die Netzwerke A, B, E, F der ersten Gruppe 21 gegenüber den Netzwerken C, D, G, H der zweiten Gruppe 22 auf Stromfluss überprüft.

Im Schritt 3 werden die Netzwerke A, C, E, G der ersten Gruppe 21 zugeteilt und die Netzwerke B, D, F, H der zweiten Gruppe 22 zugeteilt. Dann werden die Netzwerke A, C, E, G der ersten Gruppe 21 gegenüber den Netzwerken B, D, F, H der zweiten Gruppe 22 auf Stromfluss überprüft.

Nach ersten Schritt 211 ist bekannt, dass A, B, C, D von E, F, G, H isoliert sind. Nach den zweiten Schritt 212 ist auch bekannt, dass A von C, D und B von C, D getrennt sind, weiterhin E von G, H und F von G, H. Im dritten Schritt 213 ist dann zusätzlich bekannt, dass A von B, B von C, C von D, G von H, H von G und E von F getrennt sind.

Für die Messung werden lediglich nach dem in Figur 1 dargestellten Beispiel alle Netzwerke der ersten Gruppe 21 auf GND (Masse) gelegt und jeder Kontakt in jedem Netzwerk der zweiten Gruppe 22 kann parallel und selbstständig einen Stromfluss zu GND überprüfen, indem eine Spannungsquelle aufgeschaltet wird. Existiert ein Stromfluss, so wird der entsprechende Kontakt als verbunden zurückgemeldet.

Bis hierhin ist nur bekannt, dass die Netzwerke untereinander isoliert sind, aber es ist noch nicht bekannt, ob die Netzwerke selbst komplett sind. Um auch dies parallel zu überprüfen, wird nach dem Beispiel der Figur 1 für jedes Netzwerk der ersten Gruppe 21 lediglich ein Kontakt auf GND gelegt. Dann sollten alle restlichen Kontakte der Netzwerke der ersten Gruppe 21 mit einem Stromfluss rückgemeldet werden. Kontakte von Netzwerken der zweiten Gruppe 22 dürfen bei richtiger Isolierung nicht zurückgemeldet werden. Sind alle Kontakte der Netzwerke der ersten Gruppe 21 zurückgemeldet, sind die Netzwerke vollständig.

Wenn ein Kontakt eines Netzwerkes, also einer Gruppe von elektrisch verbundenen Kontakten, auf GND gelegt wird, dann kann bei jedem anderen Pin dieses Netzwerkes sofort ein Stromfluss festgestellt werden, wenn eine Spannungsquelle angelegt wird, denn es erfolgt ein Abfluss nach GND. Bei Kontakten, die nicht mit dem obigen Netzwerk verbunden sind, fließt hingegen kein Strom, wenn eine Spannungsquelle angelegt wird, folglich kann eine Isolation festgestellt werden. Es kann also in einem Schritt festgestellt werden, ob die Netzwerke der ersten Gruppe 21 gegen die Netzwerke der zweiten Gruppe 22 isoliert sind und ob ein Netzwerk komplett ist.

Da bei der zuvor beschriebenen Vorgehensweise nicht alle Netzwerke auf Vollständigkeit überprüft werden, z.B. ist Netzwerk H nie in der ersten Gruppe 21, werden einfach in jeder Messung einmal die Netzwerke der ersten Gruppe 21 auf GND gelegt, oder besser gesagt: ein Kontakt jedes Netzwerks der ersten Gruppe 21 auf GND gelegt, und dann in einer zweiten Messung die Netzwerke der zweiten Gruppe 22.

Neben der Isolierung der Netzwerke untereinander ist nun auch bekannt, dass die Netzwerke selbst vollständig sind. Nach dem Beispiel der Figur 1 sind alle vier Kontakte eines Netzwerks untereinander verbunden.

In anderen Worten ausgedrückt gilt: erste Gruppe 21 auf GND, zweite Gruppe 22 hängt an der Spannungsquelle; ein Isolationstest kann zwischen beiden Gruppen 21, 22 durchgeführt werden. Um nun gleichzeitig auf Vollständigkeit zu prüfen, wird in der ersten Gruppe 21 je Netzwerk nur ein Kontakt auf GND gelegt, die restlichen Kontakte werden wie alle Kontakte der zweiten Gruppe 22 an die Spannungsversorgung angeschlossen.

Als gewünschtes Resultat ergibt sich ein Stromfluss an den Kontakten der ersten Gruppe 21, die an der Spannungsquelle hängen (Abfluss nach GND), d.h., die Netzwerke sind vollständig. Als weiteres gewünschtes Resultat ergibt sich kein Stromfluss an den Kontakten der ersten Gruppe 21, die an der Spannungsquelle hängen (kein Abfluss nach GND), d.h., die Netzwerke der ersten und zweiten Gruppe 21, 22 sind isoliert.

Die Figuren 2a, 2b und 2c zeigen jeweils schematische Darstellungen beispielhafter elektrischer Netzwerke 11, 12, 13.

Es handelt sich bei den elektrischen Netzwerken 11, 12 und 13 um Beispiele von Netzwerken eines Kabelbaumes, die über das erfindungsgemäße Verfahren auf elektrische Isolation geprüft werden können.

Figur 2a zeigt ein erstes beispielhaftes elektrisches Netzwerk 11 mit vier elektrischen Kontakten 111, 112, 113, 114, die über elektrische Leitungen 121, 122, 123, 124 miteinander verbunden sind. In diesem Beispiel werden die elektrischen Leitungen 121, 122, 123, 124 über einen Sternpunkt 120 geführt, der die elektrischen Leitungen 121, 122, 123, 124 untereinander verbindet.

Figur 2b zeigt ein zweites beispielhaftes elektrisches Netzwerk 12 mit vier elektrischen Kontakten 111, 112, 113, 114, die über elektrische Leitungen 121, 122, 123, 124 miteinander verbunden sind. In diesem Beispiel werden die elektrischen Leitungen 121, 122, 123 über einen Sternpunkt 120 geführt, der die elektrischen Leitungen 121, 122, 123 untereinander verbindet. Eine vierte elektrische Leitung 124 verbindet einen dritten elektrischen Kontakt 113 mit einem vierten elektrischen Kontakt 114.

Figur 2c zeigt ein drittes beispielhaftes elektrisches Netzwerk 13 mit fünf elektrischen Kontakten 111, 112, 113, 114, 115 die über elektrische Leitungen 121, 122, 123, 124 miteinander verbunden sind. In diesem Beispiel sind jeweils zwei elektrisch Kontakte über eine elektrische Leitung verbunden, d.h., die Kontakte 111 und 112 über die Leitung 121; die Kontakte 112 und 113 über die Leitung 122; die Kontakte 113 und 114 über die Leitung 123; und die Kontakte 114 und 115 über die Leitung 124. Die Kontakte 114 und 115 können sich innerhalb einer Lüsterklemme 130 befinden.

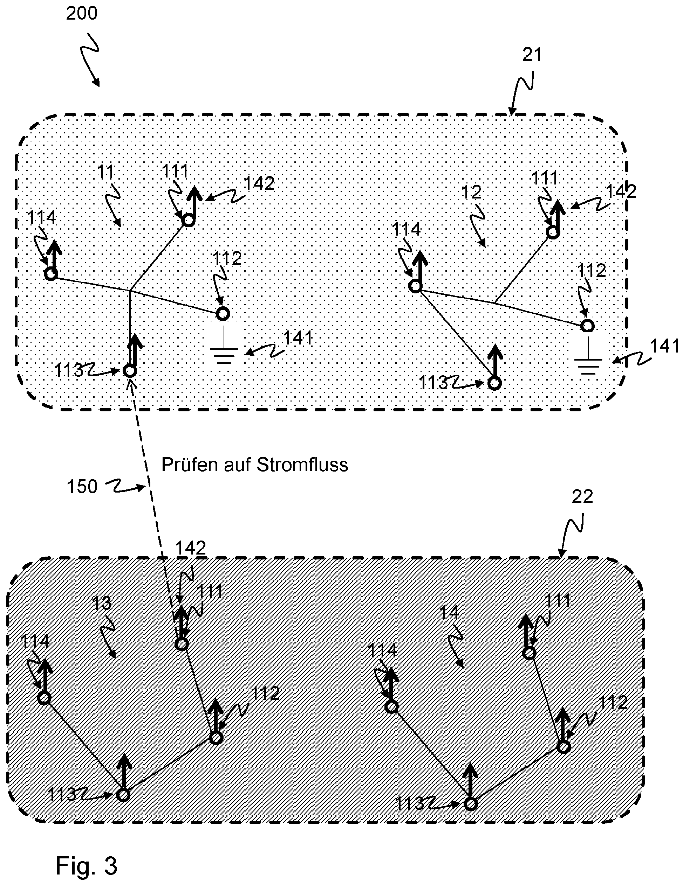

Fig. 3 zeigt eine schematische Darstellung eines erfindungsgemäßen Verfahrens 200 zur Isolationsprüfung einer Mehrzahl von elektrischen Netzwerken 11, 12, 13, 14 eines Kabelbaumes untereinander.

In diesem Verfahren 200 wird eine beispielhafte Anzahl von vier Netzwerken 11, 12, 13, 14 untereinander auf Isolation geprüft. Es kann sich beispielsweise dabei um die Netzwerke A, B, C, D wie oben in Figur 1 dargestellt handeln. Das Verfahren ist nicht auf die hier dargestellten vier Netzwerke beschränkt, sondern kann mit jeder beliebigen anderen Zahl von Netzwerken ausgeführt werden, beispielsweise mit den acht Netzwerken A, B, C, D, E, F, G, H wie oben zu Figur 1 dargestellt. Das Verfahren 200 stellt eine Verallgemeinerung des oben zu Figur 1 beschriebenen Verfahrens 100 dar.

In dem hier beschriebenen Verfahren 200 umfasst jedes elektrische Netzwerk 11, 12, 13, 14 eine Gruppe von elektrischen Kontakten 111, 112, 113, 114, welche über elektrische Leitungen 121, 122, 123, 124, wie beispielsweise in den oben beschriebenen Figuren 2a, 2b und 2c dargestellt, untereinander verbunden sind.

Das Verfahren 200 umfasst ein Gruppieren der Mehrzahl von elektrischen Netzwerken 11, 12, 13, 14 in eine erste Netzwerkgruppe 21 von elektrischen Netzwerken und eine zweite Netzwerkgruppe 22 von elektrischen Netzwerken gemäß einem Gruppierungsschema. Das Gruppieren kann beispielsweise über den zu Figur 1 beschriebenen Aufteilungs-Algorithmus 110a erfolgen.

Das Verfahren 200 umfasst ein Aufschalten eines ersten elektrischen Potentials 141 an einen ersten Kontakt 112 der Gruppe von elektrischen Kontakten eines jeden elektrischen Netzwerks der ersten Netzwerkgruppe 21 und ein Aufschalten eines zweiten elektrischen Potentials 142, das sich von dem ersten elektrischen Potential 141 unterscheidet, an die verbleibenden Kontakte 111, 113, 114 der Gruppe von elektrischen Kontakten jedes elektrischen Netzwerks der ersten Netzwerkgruppe 21 sowie an alle elektrischen Kontakte 111, 112, 113, 114 der Gruppe von elektrischen Kontakten jedes elektrischen Netzwerks der zweiten Netzwerkgruppe 22.

Das Verfahren 200 umfasst ein Prüfen der an das zweite elektrische Potential 142 geschalteten elektrischen Kontakte 111, 112, 113, 114 der zweiten Netzwerkgruppe 22 auf Stromfluss 150.

Das Verfahren 200 umfasst ferner ein Detektieren einer elektrischen Isolation zwischen den elektrischen Netzwerken der zweiten Netzwerkgruppe 22 und den elektrischen Netzwerken der ersten Netzwerkgruppe 21, falls das Prüfen der an das zweite elektrische Potential 142 geschalteten Kontakte der zweiten Netzwerkgruppe 22 jeweils ergeben hat, dass kein Strom 150 fließt.

Das Gruppierungsschema kann in einem ersten Schritt, beispielsweise einem ersten Schritt 211 wie in Figur 1 gezeigt, eine erste Gruppierung der elektrischen Netzwerke 11, 12, 13, 14 vornehmen und in einem zweiten Schritt 212 eine zweite Gruppierung der elektrischen Netzwerke 11, 12, 13, 14 vornehmen, die sich von der ersten Gruppierung unterscheidet.

Beispielsweise kann in der ersten Gruppierung die erste Netzwerkgruppe 21 die Netzwerke A, B, C, D und die zweite Netzwerkgruppe 22 die Netzwerke E, F, G, H umfassen und in der zweiten Gruppierung kann die erste Netzwerkgruppe 21 die Netzwerke A, B, E, F und die zweite Netzwerkgruppe 22 die Netzwerke C, D, G, H umfassen, wie in Figur 1 dargestellt.

Das Aufschalten der elektrischen Potentiale 141, 142, das Prüfen der Kontakte der zweiten Netzwerkgruppe 22 auf Stromfluss 150 und das Detektieren der elektrischen Isolation kann für den zweiten Schritt 212 wiederholt werden.

Das Gruppierungsschema kann ferner in weiteren Schritten, beispielsweise einem dritten Schritt 213 wie in Figur 1 dargestellt, und weiteren nicht in Figur 1 dargestellten Schritten, jeweils weitere Gruppierungen der elektrischen Netzwerke 11, 12, 13, 14 vornehmen, die sich von vorhergehenden Gruppierungen unterscheiden.

Das Aufschalten der elektrischen Potentiale 141, 142, das Prüfen der Kontakte der zweiten Netzwerkgruppe 22 auf Stromfluss 150 und das Detektieren der elektrischen Isolation kann für die weiteren Schritte 213 wiederholt werden, bis keine weitere Gruppierung mehr vorliegt, die sich von den vorhergehenden Gruppierungen unterscheidet. In dem Beispiel der Figur 1 kann das Verfahren 200 also nach drei Schritten abbrechen. Bei einer größeren Anzahl von zu prüfenden Netzwerken können sich weitere Schritte anschließen.

In einem Beispiel kann die Mehrzahl von elektrischen Netzwerken 11, 12, 13, 14 eine Anzahl von elektrischen Netzwerken 11, 12, 13, 14 umfassen, die eine Zweierpotenz ist, beispielsweise vier Netzwerke gemäß Figur 3 oder acht Netzwerke gemäß Figur 1.

Das Aufschalten der elektrischen Potentiale 141, 142, das Prüfen der Kontakte der zweiten Netzwerkgruppe 22 auf Stromfluss 150 und das Detektieren der elektrischen Isolation kann dann jeweils für eine Anzahl an Schritten 211, 212, 213 durchgeführt werden, die dem Exponenten der Zweierpotenz entspricht, beispielsweise für drei Schritte gemäß Figur 1 oder für zwei Schritte gemäß Figur 3.

Das Gruppierungsschema kann eine gleichmäßige Gruppierung vornehmen, bei der die erste Netzwerkgruppe 21 und die zweite Netzwerkgruppe 22 eine gleiche Anzahl von elektrischen Netzwerken 11, 12, 13, 14 umfassen, beispielsweise vier Netzwerke jeweils in der ersten Gruppe 21 und in der zweiten Gruppe 22, wie in Figur 1 dargestellt oder zwei Netzwerke jeweils in der ersten Gruppe 21 und in der zweiten Gruppe 22, wie in Figur 3 dargestellt.

Alternativ können sich die jeweiligen Anzahlen von Netzwerken pro Netzwerkgruppe 21, 22 um nicht mehr als Eins voneinander unterscheiden, beispielsweise beim Prüfen einer ungeraden Anzahl von Netzwerken, wie zum Beispiel Neun, wobei vier Netzwerke sich in der ersten Gruppe 21 und fünf Netzwerke sich in der zweiten Gruppe 22 befinden können.

Das Aufschalten des ersten elektrischen Potentials 141 und das Aufschalten des zweiten elektrischen Potentials 142 an die jeweiligen Kontakte eines Netzwerks der ersten Netzwerkgruppe 21 kann gleichzeitig, nacheinander, oder gruppenweise erfolgen.

Beim gleichzeitigen Aufschalten werden alle Kontakte zur gleichen Zeit aufgeschaltet. Beim nacheinander Aufschalten wird ein Kontakt erst nach dem Aufschalten eines anderen Kontakts aufgeschaltet. Beim gruppenweisen Aufschalten werden bestimmte Gruppen von Kontakten nacheinander aufgeschaltet, wobei die Kontakte der entsprechenden Gruppe gleichzeitig oder auch nacheinander aufgeschaltet werden können.

Das Aufschalten des ersten elektrischen Potentials 141 und das Aufschalten des zweiten elektrischen Potentials 142 an die jeweiligen Kontakte eines zweiten Netzwerks 12 der ersten Netzwerkgruppe 21 kann gleichzeitig oder anschließend an das Aufschalten des ersten elektrischen Potentials 141 und das Aufschalten des zweiten elektrischen Potentials 142 an die jeweiligen Kontakte eines ersten Netzwerks 11 der ersten Netzwerkgruppe 21 erfolgen.

Das Aufschalten des zweiten elektrischen Potentials 142 an die jeweiligen Kontakte eines Netzwerks 13 der zweiten Netzwerkgruppe 22 kann gleichzeitig oder anschließend an das Aufschalten des zweiten elektrischen Potentials 142 an die jeweiligen Kontakte eines Netzwerks 11 der ersten Netzwerkgruppe 21 erfolgen.

Es versteht sich, dass es ferner noch eine Vielzahl weiterer Aufschaltmöglichkeiten gibt, die hier nicht explizit erwähnt wurden.

Das erste elektrische Potential 141 kann beispielsweise ein Masse-Potential sein. Das zweite elektrische Potential 142 kann ein Referenzpotential sein, das durch ein Anlegen einer Referenzspannung oder eines Referenzstroms erzeugt wird.

Das Verfahren 200 kann ferner die folgenden Schritte umfassen: Prüfen der an das zweite Potential 142 geschalteten Kontakte der ersten Netzwerkgruppe 21 auf Stromfluss; und Detektieren einer Vollständigkeit der elektrischen Netzwerke 11, 12 der ersten Netzwerkgruppe 21, falls das Prüfen der an das zweite Potential 142 geschalteten Kontakte der ersten Netzwerkgruppe 21 jeweils einen Stromfluss ergeben hat. Vollständigkeit bedeutet hier, dass alle Kontakte 111, 112, 113, 114 untereinander durch elektrische Leitungen verbunden sind.

Das Verfahren 200 kann ferner die folgenden Schritte umfassen: Umschalten des zweiten elektrischen Potentials 142 auf das erste elektrische Potential 141 an einem ersten Kontakt 111 der Gruppe von elektrischen Kontakten eines jeden elektrischen Netzwerks der zweiten Netzwerkgruppe 22; Prüfen der an das zweite Potential 142 geschalteten Kontakte der zweiten Netzwerkgruppe 22 auf Stromfluss; und Detektieren einer Vollständigkeit der elektrischen Netzwerke der zweiten Netzwerkgruppe 22, falls das Prüfen der an das zweite Potential 142 geschalteten Kontakte der zweiten Netzwerkgruppe 22 jeweils einen Stromfluss ergeben hat.

Beispielsweise kann zumindest ein elektrischer Kontakt von zumindest einem elektrischen Netzwerk einen Steckkontakt umfassen. Die elektrischen Kontakte können in dem Kabelbaum als Steckkontakte ausgeführt sein, in welche die elektrischen Kontakte eingesteckt werden können, um einen elektrischen Kontakt herzustellen.

Das Verfahren 200 kann mittels eines Computerprogramms ausgeführt werden. Ein solches Computerprogramm umfasst Befehle, die bei der Ausführung des Programms durch einen Computer diesen veranlassen, das Verfahren 200 auszuführen.

Die oben genannten Befehle können auf einem computerlesbaren Speichermedium gespeichert sein. Ein solches computerlesbares Speichermedium umfasst Befehle, die bei der Ausführung durch einen Computer diesen veranlassen, das Verfahren 200 auszuführen.

Das Verfahren 200 lässt sich als Algorithmus implementieren, der durch einen Programmcode eines Computerprogramms auf einem Computer oder Prozessor, beispielsweise einem Steuerrechner eines Prüfsystems, ausgeführt werden kann.

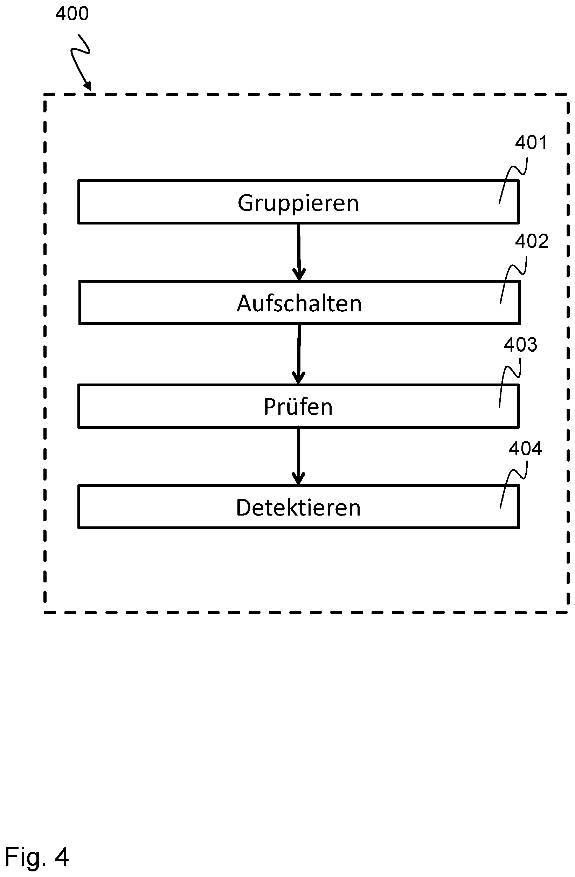

Fig. 4 zeigt eine schematische Darstellung eines erfindungsgemäßen Prüfsystems 400 zur Isolationsprüfung einer Mehrzahl von elektrischen Netzwerken eines Kabelbaumes untereinander.

Mit dem Prüfsystem 400 kann das oben beschriebene Verfahren 200 implementiert werden.

Das Prüfsystem 400 dient zur Isolationsprüfung einer Mehrzahl von elektrischen Netzwerken, beispielsweise den in Figur 3 beschriebenen Netzwerken 11, 12, 13, 14, eines Kabelbaumes untereinander, wobei jedes elektrische Netzwerk 11 eine Gruppe von elektrischen Kontakten 111, 112, 113, 114 umfasst, welche über elektrische Leitungen 121, 122, 123, 124 untereinander verbunden sind, wie in den Figuren 2a, 2b, 2c und 3 dargestellt.

Das Prüfsystem 400 umfasst eine Systemkomponente 401 zum Gruppieren der Mehrzahl von elektrischen Netzwerke 11, 12, 13, 14 in eine erste Netzwerkgruppe 21 von elektrischen Netzwerken und eine zweite Netzwerkgruppe 22 von elektrischen Netzwerken gemäß einem Gruppierungsschema.

Das Prüfsystem 400 umfasst eine Systemkomponente 402 zum Aufschalten eines ersten elektrischen Potentials 141 an einen ersten Kontakt der Gruppe von elektrischen Kontakten eines jeden elektrischen Netzwerks der ersten Netzwerkgruppe 21 und zum Aufschalten eines zweiten elektrischen Potentials 142, das sich von dem ersten elektrischen Potential 141 unterscheidet, an die verbleibenden Kontakte der Gruppe von elektrischen Kontakten jedes elektrischen Netzwerks der ersten Netzwerkgruppe 21 sowie an alle Kontakte der Gruppe von elektrischen Kontakten jedes elektrischen Netzwerks der zweiten Netzwerkgruppe 22.

Das Prüfsystem 400 umfasst eine Systemkomponente 403 zum Prüfen der an das zweite Potential 142 geschalteten Kontakte der zweiten Netzwerkgruppe 22 auf Stromfluss 150.

Das Prüfsystem 400 umfasst ferner eine Systemkomponente 404 zum Detektieren einer elektrischen Isolation zwischen den elektrischen Netzwerken der zweiten Netzwerkgruppe 22 und den elektrischen Netzwerken der ersten Netzwerkgruppe 21, falls das Prüfen der an das zweite Potential 142 geschalteten Kontakte der zweiten Netzwerkgruppe 22 jeweils ergeben hat, dass kein Strom fließt.

### BEZUGSZEICHENLISTE

- 100, 200: Verfahren zur Isolationsprüfung von elektrischen Netzwerken
- 11, 12, 13, 14: erstes, zweites, drittes und viertes Netzwerk bzw. A, B, C, D
- 15, 16, 17, 18: fünftes, sechstes, siebentes und achtes Netzwerk bzw. E, F, G, H
- 110a: Aufteilungs-Algorithmus bzw. Gruppierung der Netzwerke in Netzwerkgruppen
- 21: erste Netzwerkgruppe bzw. erste Gruppe
- 22: zweite Netzwerkgruppe bzw. zweite Gruppe
- 110b: elektrischer Messvorgang
- 211: erster Schritt, Schritt 1
- 212: zweiter Schritt, Schritt 2
- 213: dritter Schritt, Schritt 3
- 111, 112, 113: erster, zweiter und dritter elektrischer Kontakt
- 114, 115: vierter und fünfter elektrischer Kontakt
- 121, 122, 123: erste, zweite und dritte elektrische Verbindungsleitung
- 124: vierte elektrische Verbindungsleitung
- 120: elektrischer Sternpunkt
- 130: Lüsterklemme
- 141: erstes elektrisches Potential, z.B. Masse
- 142: zweites elektrisches Potential, z.B. Referenzpotential gegen Masse
- 150: Stromfluss
- 400: Prüfsystem zur Isolationsprüfung von elektrischen Netzwerken
- 401: Systemkomponente zum Gruppieren
- 402: Systemkomponente zum Aufschalten
- 403: Systemkomponente zum Prüfen
- 404: Systemkomponente zum Detektieren

## Patentansprüche

1. Verfahren (200) zur Isolationsprüfung einer Mehrzahl von elektrischen Netzwerken (11, 12, 13, 14) eines Kabelbaumes untereinander, wobei jedes elektrische Netzwerk (11, 12, 13, 14) eine Gruppe von elektrischen Kontakten (111, 112, 113, 114) umfasst, welche über elektrische Leitungen (121, 122, 123, 124) untereinander verbunden sind; wobei das Verfahren folgendes umfasst:
Gruppieren der Mehrzahl von elektrischen Netzwerken (11, 12) in eine erste Netzwerkgruppe (21) von elektrischen Netzwerken und eine zweite Netzwerkgruppe (22) von elektrischen Netzwerken gemäß einem Gruppierungsschema, wobei das Gruppierungsschema in einem ersten Schritt (211) eine erste Gruppierung der elektrischen Netzwerke (11, 12) vornimmt und in einem zweiten Schritt (212) eine zweite Gruppierung der elektrischen Netzwerke (11, 12) vornimmt, die sich von der ersten Gruppierung unterscheidet, und das Gruppierungsschema in weiteren Schritten (213) jeweils weitere Gruppierungen der elektrischen Netzwerke (11, 12) vornimmt, die sich von vorhergehenden Gruppierungen unterscheiden;
Aufschalten eines ersten elektrischen Potentials (141) an einen ersten Kontakt (112) der Gruppe von elektrischen Kontakten eines jeden elektrischen Netzwerks der ersten Netzwerkgruppe (21) und Aufschalten eines zweiten elektrischen Potentials (142), das sich von dem ersten elektrischen Potential (141) unterscheidet, an die verbleibenden Kontakte (111, 113, 114) der Gruppe von elektrischen Kontakten jedes elektrischen Netzwerks der ersten Netzwerkgruppe (21) sowie an alle elektrischen Kontakte (111, 112, 113, 114) der Gruppe von elektrischen Kontakten jedes elektrischen Netzwerks der zweiten Netzwerkgruppe (22);
Prüfen der an das zweite elektrische Potential (142) geschalteten elektrischen Kontakte (111, 112, 113, 114) der zweiten Netzwerkgruppe (22) auf Stromfluss (150); und
Detektieren einer elektrischen Isolation zwischen den elektrischen Netzwerken der zweiten Netzwerkgruppe (22) und den elektrischen Netzwerken der ersten Netzwerkgruppe (21), falls das Prüfen der an das zweite elektrische Potential (142) geschalteten Kontakte der zweiten Netzwerkgruppe (22) jeweils ergeben hat, dass kein Strom (150) fließt,
wobei das Aufschalten der elektrischen Potentiale, das Prüfen der Kontakte der zweiten Netzwerkgruppe auf Stromfluss und das Detektieren der elektrischen Isolation für den zweiten Schritt (212) und für die weiteren Schritte (213) wiederholt wird, bis keine weitere Gruppierung mehr vorliegt, die sich von den vorhergehenden Gruppierungen unterscheidet.

2. Verfahren (200) nach Anspruch 1,
wobei die Mehrzahl von elektrischen Netzwerken (11, 12) eine Anzahl von elektrischen Netzwerken (11, 12) umfasst, die eine Zweierpotenz ist; und
wobei das Aufschalten der elektrischen Potentiale (141, 142), das Prüfen der Kontakte der zweiten Netzwerkgruppe (22) auf Stromfluss (150) und das Detektieren der elektrischen Isolation jeweils für eine Anzahl an Schritten (211, 212, 213) durchgeführt wird, die dem Exponenten der Zweierpotenz entspricht.

3. Verfahren (200) nach einem der vorstehenden Ansprüche,
wobei das Gruppierungsschema eine gleichmäßige Gruppierung vornimmt, bei der die erste Netzwerkgruppe (21) und die zweite Netzwerkgruppe (22) eine gleiche Anzahl von elektrischen Netzwerken (11, 12) umfassen oder bei der die jeweiligen Anzahlen sich um nicht mehr als Eins voneinander unterscheiden.

4. Verfahren (200) nach einem der vorstehenden Ansprüche,
wobei das Aufschalten des ersten elektrischen Potentials (141) und das Aufschalten des zweiten elektrischen Potentials (142) an die jeweiligen Kontakte eines Netzwerks der ersten Netzwerkgruppe (21) gleichzeitig oder nacheinander oder gruppenweise erfolgt.

5. Verfahren (200) nach einem der vorstehenden Ansprüche,
wobei das Aufschalten des ersten elektrischen Potentials (141) und das Aufschalten des zweiten elektrischen Potentials (142) an die jeweiligen Kontakte eines zweiten Netzwerks (12) der ersten Netzwerkgruppe (21) gleichzeitig oder anschließend an das Aufschalten des ersten elektrischen Potentials (141) und das Aufschalten des zweiten elektrischen Potentials (142) an die jeweiligen Kontakte eines ersten Netzwerks (11) der ersten Netzwerkgruppe (21) erfolgt.

6. Verfahren (200) nach einem der vorstehenden Ansprüche,
wobei das Aufschalten des zweiten elektrischen Potentials (142) an die jeweiligen Kontakte eines Netzwerks (13) der zweiten Netzwerkgruppe (22) gleichzeitig oder anschließend an das Aufschalten des zweiten elektrischen Potentials (142) an die jeweiligen Kontakte eines Netzwerks (11) der ersten Netzwerkgruppe (21) erfolgt.

7. Verfahren (200) nach einem der vorstehenden Ansprüche,
wobei das erste elektrische Potential (141) ein Masse-Potential ist; und
wobei das zweite elektrische Potential (142) ein Referenzpotential ist, das durch ein Anlegen einer Referenzspannung oder eines Referenzstroms erzeugt wird.

8. Verfahren (200) nach einem der vorstehenden Ansprüche, umfassend:
Prüfen der an das zweite Potential (142) geschalteten Kontakte der ersten Netzwerkgruppe (21) auf Stromfluss; und
Detektieren einer Vollständigkeit der elektrischen Netzwerke (11, 12) der ersten Netzwerkgruppe (21), falls das Prüfen der an das zweite Potential (142) geschalteten Kontakte der ersten Netzwerkgruppe (21) jeweils einen Stromfluss ergeben hat.

9. Verfahren (200) nach einem der vorstehenden Ansprüche, umfassend:
Umschalten des zweiten elektrischen Potentials (142) auf das erste elektrische Potential (141) an einem ersten Kontakt (111) der Gruppe von elektrischen Kontakten eines jeden elektrischen Netzwerks der zweiten Netzwerkgruppe (22);
Prüfen der an das zweite Potential (142) geschalteten Kontakte der zweiten Netzwerkgruppe (22) auf Stromfluss; und
Detektieren einer Vollständigkeit der elektrischen Netzwerke der zweiten Netzwerkgruppe (22), falls das Prüfen der an das zweite Potential (142) geschalteten Kontakte der zweiten Netzwerkgruppe (22) jeweils einen Stromfluss ergeben hat.

10. Verfahren (200) nach einem der vorstehenden Ansprüche,
wobei zumindest ein elektrischer Kontakt von zumindest einem elektrischen Netzwerk einen Steckkontakt umfasst.

11. Computerprogramm, umfassend Befehle, die bei der Ausführung des Programms durch ein Prüfsystem (400) gemäß Anspruch 13 dieses veranlassen, das Verfahren (200) nach einem der Ansprüche 1 bis 10 auszuführen.

12. Computerlesbares Speichermedium, umfassend Befehle, die bei der Ausführung durch ein Prüfsystem (400) gemäß Anspruch 13 dieses veranlassen, das Verfahren (200) nach einem der Ansprüche 1 bis 10 auszuführen.

13. Prüfsystem (400) zur Isolationsprüfung einer Mehrzahl von elektrischen Netzwerken (11, 12) eines Kabelbaumes untereinander, wobei jedes elektrische Netzwerk (11) eine Gruppe von elektrischen Kontakten (111, 112, 113, 114) umfasst, welche über elektrische Leitungen (121, 122, 123, 124) untereinander verbunden sind; wobei das Prüfsystem folgendes umfasst:
eine Systemkomponente (401), die dazu eingerichtet ist, mittels eines Aufteilungs-Algorithmus (110a) die Mehrzahl von elektrischen Netzwerken (11, 12) in eine erste Netzwerkgruppe (21) von elektrischen Netzwerken und eine zweite Netzwerkgruppe (22) von elektrischen Netzwerken gemäß einem Gruppierungsschema zu gruppieren, wobei das Gruppierungsschema in einem ersten Schritt (211) eine erste Gruppierung der elektrischen Netzwerke (11, 12) vornimmt und in einem zweiten Schritt (212) eine zweite Gruppierung der elektrischen Netzwerke (11, 12) vornimmt, die sich von der ersten Gruppierung unterscheidet, und das Gruppierungsschema in weiteren Schritten (213) jeweils weitere Gruppierungen der elektrischen Netzwerke (11, 12) vornimmt, die sich von vorhergehenden Gruppierungen unterscheiden;
eine Systemkomponente (402) zum Aufschalten eines ersten elektrischen Potentials (141) an einen ersten Kontakt der Gruppe von elektrischen Kontakten eines jeden elektrischen Netzwerks der ersten Netzwerkgruppe (21) und zum Aufschalten eines zweiten elektrischen Potentials (142), das sich von dem ersten elektrischen Potential (141) unterscheidet, an die verbleibenden Kontakte der Gruppe von elektrischen Kontakten jedes elektrischen Netzwerks der ersten Netzwerkgruppe (21) sowie an alle Kontakte der Gruppe von elektrischen Kontakten jedes elektrischen Netzwerks der zweiten Netzwerkgruppe (22);
eine Systemkomponente (403) zum Prüfen der an das zweite Potential (142) geschalteten Kontakte der zweiten Netzwerkgruppe (22) auf Stromfluss (150); und
eine Systemkomponente (404) zum Detektieren einer elektrischen Isolation zwischen den elektrischen Netzwerken der zweiten Netzwerkgruppe (22) und den elektrischen Netzwerken der ersten Netzwerkgruppe (21), falls das Prüfen der an das zweite Potential (142) geschalteten Kontakte der zweiten Netzwerkgruppe (22) jeweils ergeben hat, dass kein Strom fließt,
wobei das System dazu eingerichtet ist, das Aufschalten der elektrischen Potentiale, das Prüfen der Kontakte der zweiten Netzwerkgruppe auf Stromfluss und das Detektieren der elektrischen Isolation für den zweiten Schritt (212) und für die weiteren Schritte (213) zu wiederholen, bis keine weitere Gruppierung mehr vorliegt, die sich von den vorhergehenden Gruppierungen unterscheidet.

## Claims

1. Method (200) for testing the insulation of a plurality of electrical networks (11, 12, 13, 14) of a cable harness with respect to one another, wherein each electrical network (11, 12, 13, 14) comprises a group of electrical contacts (111, 112, 113, 114) connected to one another via electrical lines (121, 122, 123, 124); wherein the method comprises the following:
grouping the plurality of electrical networks (11, 12) into a first network group (21) of electrical networks and a second network group (22) of electrical networks in accordance with a grouping scheme, wherein the grouping scheme, in a first step (211), carries out a first grouping of the electrical networks (11, 12) and, in a second step (212), carries out a second grouping of the electrical networks (11, 12) that differs from the first grouping, and the grouping scheme, in further steps (213), carries out respective further groupings of the electrical networks (11, 12) that differ from previous groupings;
connecting a first electrical potential (141) to a first contact (112) of the group of electrical contacts of each electrical network of the first network group (21) and connecting a second electrical potential (142), different from the first electrical potential (141), to the remaining contacts (111, 113, 114) of the group of electrical contacts of each electrical network of the first network group (21) and to all electrical contacts (111, 112, 113, 114) of the group of electrical contacts of each electrical network of the second network group (22) ;
testing the electrical contacts (111, 112, 113, 114) of the second network group (22) that are connected to the second electrical potential (142) for a current flow (150); and
detecting electrical insulation between the electrical networks of the second network group (22) and the electrical networks of the first network group (21) if each of the tests of the contacts of the second network group (22) that are connected to the second electrical potential (142) revealed that no current (150) is flowing,
wherein the processes of connecting the electrical potentials, testing the contacts of the second network group for a current flow and detecting the electrical insulation are repeated for the second step (212) and for the further steps (213) until there are no further groupings that differ from the previous groupings.

2. Method (200) according to Claim 1,
wherein the plurality of electrical networks (11, 12) comprises a number of electrical networks (11, 12) that is a power of two; and
wherein the electrical potentials (141, 142) are connected, the contacts of the second network group (22) are tested for a current flow (150) and the electrical insulation is detected in each case for a number of steps (211, 212, 213) that corresponds to the exponent of the power of two.

3. Method (200) according to either of the preceding claims,
wherein the grouping scheme carries out uniform grouping in which the first network group (21) and the second network group (22) comprise an equal number of electrical networks (11, 12) or in which the respective numbers differ from one another by no more than one.

4. Method (200) according to one of the preceding claims,
wherein the first electrical potential (141) and the second electrical potential (142) are connected to the respective contacts of a network of the first network group (21) simultaneously or successively or in groups.

5. Method (200) according to one of the preceding claims,
wherein the first electrical potential (141) and the second electrical potential (142) are connected to the respective contacts of a second network (12) of the first network group (21) at the same time as or following the connection of the first electrical potential (141) and the connection of the second electrical potential (142) to the respective contacts of a first network (11) of the first network group (21).

6. Method (200) according to one of the preceding claims,
wherein the second electrical potential (142) is connected to the respective contacts of a network (13) of the second network group (22) at the same time as or following the connection of the second electrical potential (142) to the respective contacts of a network (11) of the first network group (21).

7. Method (200) according to one of the preceding claims,
wherein the first electrical potential (141) is a ground potential; and
wherein the second electrical potential (142) is a reference potential generated by applying a reference voltage or a reference current.

8. Method (200) according to one of the preceding claims, comprising:
testing the contacts of the first network group (21) that are connected to the second potential (142) for a current flow; and
detecting completeness of the electrical networks (11, 12) of the first network group (21) if each of the tests of the contacts of the first network group (21) that are connected to the second potential (142) revealed a current flow.

9. Method (200) according to one of the preceding claims, comprising:
switching the second electrical potential (142) over to the first electrical potential (141) at a first contact (111) of the group of electrical contacts of each electrical network of the second network group (22);
testing the contacts of the second network group (22) that are connected to the second potential (142) for a current flow; and
detecting completeness of the electrical networks of the second network group (22) if each of the tests of the contacts of the second network group (22) that are connected to the second potential (142) revealed a current flow.

10. Method (200) according to one of the preceding claims,
wherein at least one electrical contact of at least one electrical network comprises a plug contact.

11. Computer program comprising instructions that, when the program is executed by a test system (400) according to Claim 13, cause said test system to carry out the method (200) according to one of Claims 1 to 10.

12. Computer-readable storage medium comprising instructions that, when executed by a test system (400) according to Claim 13, cause said test system to carry out the method (200) according to one of Claims 1 to 10.

13. Test system (400) for testing the insulation of a plurality of electrical networks (11, 12) of a cable harness with respect to one another, wherein each electrical network (11) comprises a group of electrical contacts (111, 112, 113, 114) connected to one another via electrical lines (121, 122, 123, 124); wherein the test system comprises the following:
a system component (401) configured, by way of a distribution algorithm (110a), to group the plurality of electrical networks (11, 12) into a first network group (21) of electrical networks and a second network group (22) of electrical networks in accordance with a grouping scheme, wherein the grouping scheme, in a first step (211), carries out a first grouping of the electrical networks (11, 12) and, in a second step (212), carries out a second grouping of the electrical networks (11, 12) that differs from the first grouping, and the grouping scheme, in further steps (213), carries out respective further groupings of the electrical networks (11, 12) that differ from previous groupings;
a system component (402) for connecting a first electrical potential (141) to a first contact of the group of electrical contacts of each electrical network of the first network group (21) and for connecting a second electrical potential (142), different from the first electrical potential (141), to the remaining contacts of the group of electrical contacts of each electrical network of the first network group (21) and to all contacts of the group of electrical contacts of each electrical network of the second network group (22); a system component (403) for testing the contacts of the second network group (22) that are connected to the second potential (142) for a current flow (150); and
a system component (404) for detecting electrical insulation between the electrical networks of the second network group (22) and the electrical networks of the first network group (21) if each of the tests of the contacts of the second network group (22) that are connected to the second potential (142) revealed that no current is flowing,
wherein the system is configured to repeat the processes of connecting the electrical potentials, testing the contacts of the second network group for a current flow and detecting the electrical insulation for the second step (212) and for the further steps (213) until there are no further groupings that differ from the previous groupings.

## Revendications

1. Procédé (200) de test d'isolation d'une pluralité de réseaux électriques (11, 12, 13, 14) d'un faisceau électrique les uns par rapport aux autres, chaque réseau électrique (11, 12, 13, 14) comprenant un groupe de contacts électriques (111, 112, 113, 114) qui sont reliés entre eux par l'intermédiaire de lignes électriques (121, 122, 123, 124) ; le procédé comprenant :
le regroupement de la pluralité de réseaux électriques (11, 12) en un premier groupe de réseaux (21) constitué de réseaux électriques et un deuxième groupe de réseaux (22) constitué de réseaux électriques selon un schéma de regroupement, le schéma de regroupement effectuant, lors d'une première étape (211), un premier regroupement des réseaux électriques (11, 12) et effectuant, lors d'une deuxième étape (212), un deuxième regroupement des réseaux électriques (11, 12) qui diffère du premier regroupement, et le schéma de regroupement effectuant, lors d'étapes supplémentaires (213), respectivement d'autres regroupements des réseaux électriques (11, 12) qui diffèrent des regroupements précédents ;
l'application d'un premier potentiel électrique (141) à un premier contact (112) du groupe de contacts électriques de chaque réseau électrique du premier groupe de réseaux (21) et l'application d'un deuxième potentiel électrique (142), qui diffère du premier potentiel électrique (141), aux contacts restants (111, 113, 114) du groupe de contacts électriques de chaque réseau électrique du premier groupe de réseaux (21) ainsi qu'à tous les contacts électriques (111, 112, 113, 114) du groupe de contacts électriques de chaque réseau électrique du deuxième groupe de réseaux (22) ;
le test de passage de courant (150) au niveau des contacts électriques (111, 112, 113, 114) du deuxième groupe de réseaux (22) connectés au deuxième potentiel électrique (142) ; et
la détection d'une isolation électrique entre les réseaux électriques du deuxième groupe de réseaux (22) et les réseaux électriques du premier groupe de réseaux (21), si le test des contacts du deuxième groupe de réseaux (22) connectés au deuxième potentiel électrique (142) a respectivement révélé qu'aucun courant (150) ne circule, dans lequel l'application des potentiels électriques, le test de passage de courant au niveau des contacts du deuxième groupe de réseaux et la détection de l'isolation électrique sont répétés pour la deuxième étape (212) et pour les étapes supplémentaires (213) jusqu'à ce qu'il n'y ait plus d'autre regroupement qui diffèrent des regroupements précédents.

2. Procédé (200) selon la revendication 1,
dans lequel la pluralité de réseaux électriques (11, 12) comprend un nombre de réseaux électriques (11, 12) qui est une puissance de deux ; et
dans lequel l'application des potentiels électriques (141, 142), le test de passage de courant (150) au niveau des contacts du deuxième groupe de réseaux (22) et la détection de l'isolation électrique sont respectivement effectués pour un nombre d'étapes (211, 212, 213) qui correspond à l'exposant de la puissance de deux.

3. Procédé (200) selon l'une quelconque des revendications précédentes,
dans lequel le schéma de regroupement effectue un regroupement régulier dans lequel le premier groupe de réseaux (21) et le deuxième groupe de réseaux (22) comprennent un même nombre de réseaux électriques (11, 12) ou dans lequel les nombres respectifs ne diffèrent pas l'un de l'autre de plus d'un.

4. Procédé (200) selon l'une quelconque des revendications précédentes,
dans lequel l'application du premier potentiel électrique (141) et l'application du deuxième potentiel électrique (142) aux contacts respectifs d'un réseau du premier groupe de réseaux (21) s'effectuent simultanément ou successivement ou par groupes.

5. Procédé (200) selon l'une quelconque des revendications précédentes,
dans lequel l'application du premier potentiel électrique (141) et l'application du deuxième potentiel électrique (142) aux contacts respectifs d'un deuxième réseau (12) du premier groupe de réseaux (21) s'effectuent simultanément ou ultérieurement à l'application du premier potentiel électrique (141) et à l'application du deuxième potentiel électrique (142) aux contacts respectifs d'un premier réseau (11) du premier groupe de réseaux (21).

6. Procédé (200) selon l'une quelconque des revendications précédentes,
dans lequel l'application du deuxième potentiel électrique (142) aux contacts respectifs d'un réseau (13) du deuxième groupe de réseaux (22) s'effectue simultanément ou ultérieurement à l'application du deuxième potentiel électrique (142) aux contacts respectifs d'un réseau (11) du premier groupe de réseaux (21).

7. Procédé (200) selon l'une quelconque des revendications précédentes,
dans lequel le premier potentiel électrique (141) est un potentiel de masse ; et
dans lequel le deuxième potentiel électrique (142) est un potentiel de référence qui est généré par l'application d'une tension de référence ou d'un courant de référence.

8. Procédé (200) selon l'une quelconque des revendications précédentes, comprenant :
le test de passage de courant au niveau des contacts du premier groupe de réseaux (21) connectés au deuxième potentiel (142) ; et
la détection d'un caractère complet des réseaux électriques (11, 12) du premier groupe de réseaux (21), si le test des contacts du premier groupe de réseaux (21) connectés au deuxième potentiel (142) a respectivement révélé un passage de courant.

9. Procédé (200) selon l'une quelconque des revendications précédentes, comprenant :
la commutation du deuxième potentiel électrique (142) sur le premier potentiel électrique (141) au niveau d'un premier contact (111) du groupe de contacts électriques de chaque réseau électrique du deuxième groupe de réseaux (22) ;
le test de passage de courant au niveau des contacts du deuxième groupe de réseaux (22) connectés au deuxième potentiel (142) ; et
la détection d'un caractère complet des réseaux électriques du deuxième groupe de réseaux (22), si le test des contacts du deuxième groupe de réseaux (22) connectés au deuxième potentiel (142) a respectivement révélé un passage de courant.

10. Procédé (200) selon l'une quelconque des revendications précédentes,
dans lequel au moins un contact électrique d'au moins un réseau électrique comprend un contact à fiche.

11. Programme informatique, comprenant des instructions qui, lors de l'exécution du programme par un système de test (400) selon la revendication 13, amènent celui-ci à mettre en œuvre le procédé (200) selon l'une quelconque des revendications 1 à 10.

12. Support de stockage lisible par ordinateur comprenant des instructions qui, lors de l'exécution par un système de test (400) selon la revendication 13, amènent celui-ci à mettre en œuvre le procédé (200) selon l'une quelconque des revendications 1 à 10.

13. Système de test (400) pour tester l'isolation d'une pluralité de réseaux électriques (11, 12) d'un faisceau électrique les uns par rapport aux autres, chaque réseau électrique (11) comprenant un groupe de contacts électriques (111, 112, 113, 114) qui sont reliés entre eux par l'intermédiaire de lignes électriques (121, 122, 123, 124) ; le système de test comprenant :
un composant de système (401) qui est configuré pour regrouper, au moyen d'un algorithme de répartition (110a), la pluralité de réseaux électriques (11, 12) en un premier groupe de réseaux (21) constitué de réseaux électriques et un deuxième groupe de réseaux (22) constitué de réseaux électriques selon un schéma de regroupement, le schéma de regroupement effectuant, lors d'une première étape (211), un premier regroupement des réseaux électriques (11, 12) et effectuant, lors d'une deuxième étape (212), un deuxième regroupement des réseaux électriques (11, 12) qui diffère du premier regroupement, et le schéma de regroupement effectuant, lors d'étapes supplémentaires (213), respectivement d'autres regroupements des réseaux électriques (11, 12) qui diffèrent des regroupements précédents ;
un composant de système (402) pour l'application d'un premier potentiel électrique (141) à un premier contact du groupe de contacts électriques de chaque réseau électrique du premier groupe de réseaux (21) et pour l'application d'un deuxième potentiel électrique (142), qui diffère du premier potentiel électrique (141), aux contacts restants du groupe de contacts électriques de chaque réseau électrique du premier groupe de réseaux (21) ainsi qu'à tous les contacts du groupe de contacts électriques de chaque réseau électrique du deuxième groupe de réseaux (22) ;
un composant de système (403) pour le test de passage de courant (150) au niveau des contacts du deuxième groupe de réseaux (22) connectés au deuxième potentiel (142) ; et
un composant de système (404) pour la détection d'une isolation électrique entre les réseaux électriques du deuxième groupe de réseaux (22) et les réseaux électriques du premier groupe de réseaux (21), si le test des contacts du deuxième groupe de réseaux (22) connectés au deuxième potentiel (142) a respectivement révélé qu'aucun courant ne circule,
dans lequel le système est configuré pour répéter l'application des potentiels électriques, le test de passage de courant au niveau des contacts du deuxième groupe de réseaux et la détection de l'isolation électrique pour la deuxième étape (212) et pour les étapes supplémentaires (213) jusqu'à ce qu'il n'y ait plus d'autre regroupement qui différe des regroupements précédents.
